# EUROPEAN PATENT APPLICATION

(11) **EP 4 534 985 A1**
(43) Date of publication of application: **09.04.2025**
(21) Application number: 24197657.0
(22) Date of filing: 30.08.2024
(51) Int. Cl.: G01N 21/94, G01N 21/956, G03F 7/00, H01L 21/027, H01L 21/66

(54) **FOREIGN SUBSTANCE INSPECTION METHOD, FOREIGN SUBSTANCE INSPECTION APPARATUS, MOLDING METHOD, MOLDING APPARATUS, AND ARTICLE MANUFACTURING METHOD**

(30) Priority: 31.08.2023 JP 2023141686
(71) Applicant: CANON KABUSHIKI KAISHA, Tokyo 146-8501 (JP)
(72) Inventor: ITO, Toshiki, Tokyo, 146-8501 (JP); IMAMURA, Hideki, Tokyo, 146-8501 (JP); MATSUSHIMA, Hinako, Tokyo, 146-8501 (JP); KATSUTA, Ken, Tokyo, 146-8501 (JP)
(74) Representative: Canon Europe Limited

(57) **Abstract**

A foreign substance inspection method for inspecting for a foreign substance includes bringing a first surface of a first substate into contact with a second surface of a second substrate to cause the first and second surfaces to face each other (103), obtaining an image of reflected light from the first and second surfaces in contact with each other (105), and determining, based on the obtained image, the presence of a foreign substance, or the absence of a foreign substance, or the position of a foreign substance (106).

## Description

### TECHNICAL FIELD

The present disclosure relates to a foreign substance inspection method for inspecting a substrate for a foreign substance, an inspection apparatus, a molding method, a molding apparatus, and an article manufacturing method.

### BACKGROUND

### Description of the Related Art

An article having a fine structure, such as a semiconductor device or a micro-electro-mechanical system (MEMS) device, can be manufactured by using a projection exposure apparatus and/or a molding apparatus such as an imprint apparatus. In such a microfabrication apparatus, a foreign substance on a substrate may cause a defect in an article to be manufactured. In particular, in the molding apparatus in which a composition (curable composition) on a substrate is molded by bringing a mold into contact with the composition, a foreign substance on the substrate may break the mold or decrease the life of the mold.

To reduce breakage of the mold or a decrease in the life of the mold, a substrate inspection apparatus (foreign substance inspection apparatus) is used in advance to inspect a substrate for foreign substances. A typical substrate inspection apparatus like that disclosed in, for example, Japanese Patent Laid-Open No. 2022-29829, is configured to detect the presence or absence of a foreign substance by irradiating a substrate with obliquely incident inspection light and receiving, through a photodetector, light which is scattered by the foreign substance.

Japanese Patent No. 6541518 discloses a technique for bringing a transparent mold having projections and depressions into contact with a liquid imprint resist in an imprinting manner. The technique further includes capturing an image of interference fringes, through the mold, to detect a foreign substance based on an anomaly pattern of the interference fringes.

Known foreign substance inspection apparatuses like that disclosed in Japanese Patent Laid-Open No. 2022-29829 have a limited resolution, and require a large amount of time to perform an inspection.

The technique, disclosed in Japanese Patent No. 6541518, is arranged to detect, during imprinting, the presence of a foreign substance sandwiched between the mold and the resist.

### SUMMARY

The present disclosure provides a novel technique related to a foreign substance inspection method for inspecting a substrate for a foreign substance. Known foreign substance inspection apparatuses like that disclosed in Japanese Patent Laid-Open No. 2022-29829 or Japanese Patent No. 6541518 are not able to detect a foreign substance having a size at or below the resolution limit of an image pickup device (e.g., as defined by a light scattering limit based on the photosensitivity of a photodetector of the device (e.g., up to 70 µm or up to 500 nm), and require a large amount of time to perform an inspection. Advantageously, the present disclosure is able to detect a foreign substance (e.g., before imprinting) which thereby prevents the inclusion of the foreign substance within a semiconductor structure (e.g., by preventing the foreign substance from being sandwiched between the mold and the resist during manufacture). Further, the present disclosure is able to prevent inclusion of foreign substances having a size at or below the resolution limit of an image pickup device.

The present disclosure in its first aspect provides a foreign substance inspection method as specified in claims 1 to 13.

The present disclosure in its second aspect provides a molding method as specified in claim 14.

The present disclosure in its third aspect provides a molding method as specified in claim 15.

The present disclosure in its fourth aspect provides a molding method as specified in claim 16.

The present disclosure in its fifth aspect provides a foreign substance inspection apparatus as specified in claims 17 and 18.

The present disclosure in its sixth aspect provides a molding apparatus as specified in claim 19.

The present disclosure in its seventh aspect provides an article manufacturing method as specified in claim 20.

Further features of the present disclosure will become apparent from the following description of example embodiments with reference to the attached drawings.

### BRIEF DESCRIPTION OF THE DRAWINGS

Fig. 1 is a schematic diagram of an example foreign substance inspection apparatus according to an embodiment.
Fig. 2 is a flowchart of a foreign substance inspection method according to an embodiment.
Figs. 3A and 3B are schematic diagrams illustrating a first substrate and a second substrate to be brought into contact with each other.
Fig. 4 is a schematic diagram of the principle of foreign substance detection.
Fig. 5 is a schematic diagram of the principle of occurrence of interference colors.
Figs. 6A and 6B illustrate an example shape of a first substrate according to an embodiment of the present disclosure.
Fig. 7 illustrates an example method of bringing a first substrate into contact with a second substrate according to an embodiment of the present disclosure.
Fig. 8 illustrates images captured in Example 1.
Fig. 9 illustrates an image captured in Example 2.
Figs. 10A and 10B are schematic diagrams illustrating the difference between the area of an interference-color anomaly region with a liquid layer and that with no liquid layer.
Figs. 11A to 11F schematically illustrate an example article manufacturing method according to an embodiment.

### DESCRIPTION OF THE EMBODIMENTS

Embodiments will be described in detail below with reference to the attached drawings. The following embodiments are not intended to limit the present disclosure described in the appended claims. Although features are described in the embodiments, not all of these features may be essential to the present disclosure. The features may be combined in any suitable manner. Furthermore, in the attached drawings, the same or similar components are assigned the same reference numerals to avoid redundant description.

### Foreign Substance Inspection Apparatus

A foreign substance inspection apparatus according to an embodiment includes a first holding unit configured to hold a first substrate, a second holding unit configured to hold a second substrate, a driving mechanism configured to bring a first surface of the first substrate into contact with a second surface of the second substrate to cause the first and second surfaces to face each other, an image pickup unit configured to obtain an image of reflected light from the first and second surfaces in contact with each other, and a controller configured to determine, based on the obtained image, the presence of a foreign substance, or the absence of a foreign substance, or the position of a foreign substance.

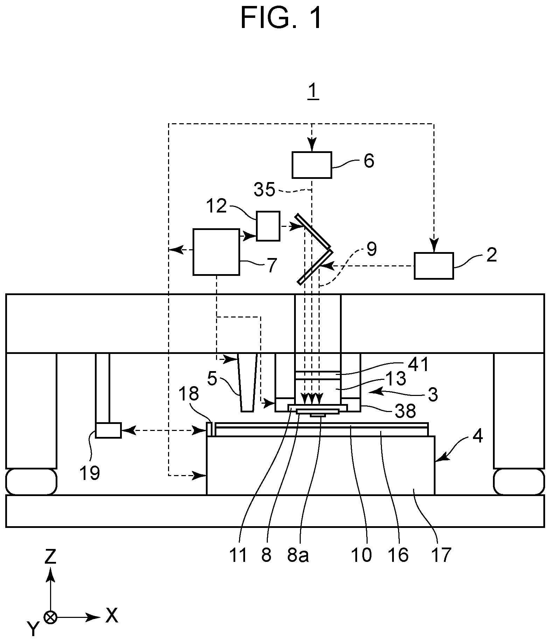

Fig. 1 is a diagram illustrating an example configuration of a foreign substance inspection apparatus 1 according to an embodiment. The configuration of the foreign substance inspection apparatus 1 will be described with reference to Fig. 1. As used herein, an XY plane refers to a plane on which a second substrate 10 is disposed, and a Z direction refers to a direction orthogonal to the XY plane. Fig. 1 illustrates the X, Y, and Z axes defined as described above.

A first substrate 8 and the second substrate 10 may be made of, for example, glass, ceramic, metal, semiconductor, or resin. Each of the first substrate 8 and the second substrate 10 may have, on its surface, a member made of a material different from that of the substrate as necessary. Specific examples of the substrate include a silicon wafer, a compound semiconductor wafer, and a quartz glass wafer.

The first substrate 8 can be a transparent substrate made of a light-transmissive material.

The first substrate 8 may include a mesa portion 8a having a flat top surface. The mesa portion 8a is a plateau-like portion having a top surface, serving as a contact surface of the first substrate 8 that is to be pressed against the second substrate 10, and protruding from its surrounding portion.

The second substrate may be made of a material that is opaque to light.

Although at least either the first substrate or the second substrate needs to be made of a light-transmissive material, both the first substrate and the second substrate may be light-transmissive.

Any of the first and second substrates may be an inspection target substrate to be subjected to foreign substance inspection. For example, a quartz glass wafer that is used for flattening and is called a "superstrate" may be used as a first substrate to be inspected. For example, a silicon wafer as a substrate to be nanoimprinted may be used as a second substrate to be inspected. An inspection target substrate can be inspected, regardless of whether the inspection target substrate is transparent to light or opaque to light.

If a first surface of the first substrate and a second surface of the second substrate have substantially the same size, inspection can be completed by performing a contact step, which will be described later, once. If the first surface of the first substrate has a smaller size than the second surface of the second substrate, inspection may be repeatedly performed on multiple regions of the second surface while the position of contact between the first and second surfaces is being shifted.

The foreign substance inspection apparatus 1 includes a first holding unit 3 that holds and moves the first substrate 8 and a second holding unit 4 that holds and moves the second substrate 10.

The foreign substance inspection apparatus 1 further includes a light irradiation system 2 that guides light 9 to be applied to the first and second surfaces, an image pickup unit 6 that captures an image of reflected light from the first and second surfaces, and a controller 7 that controls an operation of the foreign substance inspection apparatus 1.

The foreign substance inspection apparatus 1 may further include a detector 12 that detects a mark located on the first substrate or the second substrate.

The second holding unit 4 includes a substrate chuck 16 that holds the second substrate 10 and a substrate driving mechanism 17 that controls the position of the second substrate 10 relative to at least the X axis and the Y axis in the XYZ coordinate system.

The second holding unit 4 includes, on its sides, multiple reference mirrors 18 for X, Y, Z, ωx, ωy, and ωz directions.

The foreign substance inspection apparatus 1 includes multiple laser interferometers (measuring machines) 19 arranged in a one-to-one correspondence with the reference mirrors 18 so that beams can be applied to the respective reference mirrors 18 to determine the position of the second holding unit 4.

Each of the laser interferometers 19 measures the position of the second holding unit 4. The controller 7 performs positioning control for the second substrate 10 (or the second holding unit 4) based on measurement values obtained at that time.

The foreign substance inspection apparatus 1 may determine the position of the second holding unit 4 using an encoder instead of the reference mirrors 18 and the laser interferometers 19.

The second holding unit 4, which includes the substrate chuck 16 to support a lower surface of the second substrate 10, may further include multiple substrate chucks 16 to provide multiple spaces divided by the multiple substrate chucks 16. Adjusting a pressure in each of the divided spaces can deform the second substrate 10 when the first substrate is pressed against the second substrate or when the first substrate is separated from the second substrate.

For example, before the first substrate 8 is pressed against the second substrate 10, increasing a pressure in the space can deform and cause the second substrate 10 to protrude toward the first substrate 8, so that the second surface of the second substrate 10 can be brought into contact with the first surface, which is flat, of the first substrate 8.

The first holding unit 3 includes a first chuck 11 to hold the first substrate 8 and a first driving mechanism (actuator) 38. The first holding unit 3 is moved vertically (in directions along the Z axis) by the first driving mechanism 38 while the first chuck 11 is holding the first substrate 8.

The first holding unit 3 is moved downward (in the -Z direction) by the first driving mechanism 38, so that the mesa portion 8a (first surface) of the first substrate 8 comes into contact with the surface (second surface) of the second substrate 10.

After completion of foreign substance inspection, the first holding unit 3 is moved upward (in the +Z direction) by the first driving mechanism 38, so that the first substrate 8 is separated from the second substrate 10.

For the contact step and the separation, instead of the first holding unit 3, the second holding unit 4 may be moved along the Z axis. The first holding unit 3 and the second holding unit 4 may be moved relative to each other.

The first holding unit 3 may further include a light-transmissive member 41 (e.g., a quartz plate) and a space 13 defined by the light-transmissive member 41 and the first substrate 8. Adjusting a pressure in the space 13 can deform the first substrate 8 during the contract step or the separation. For example, increasing a pressure in the space 13 during the contact step can deform and cause the first substrate 8 to protrude toward the second substrate 10, so that the mesa portion 8a (first surface) can be brought into contact with the second surface.

Deformation at the first holding unit 3 can be controlled in conjunction with deformation at the above-described second holding unit 4.

The detector 12 can detect a mark located on the first substrate 8 and a mark located on the second substrate 10.

The foreign substance inspection apparatus 1 can determine relative positions of the first substrate 8 and the second substrate 10 based on detection results of the detector 12, and align the first substrate 8 and the second substrate 10 by moving at least one of the first substrate 8 and the second substrate 10.

The controller 7 controls operations of the mechanisms of the foreign substance inspection apparatus 1 to bring the first surface into contact with one or more shot regions located on the second substrate 10 and perform foreign substance inspection. The controller 7 may be configured to control the first holding unit 3, the second holding unit 4, a supply unit 5, the light irradiation system 2, and the detector 12. The controller 7 may be incorporated in the foreign substance inspection apparatus 1 or may be disposed in a different location from the foreign substance inspection apparatus 1 and remotely control the foreign substance inspection apparatus 1.

The above-described foreign substance inspection apparatus 1 provided with the supply unit 5 for a curable composition can serve as a molding apparatus. The image pickup unit 6 may include a mechanism to emit light 35. The light irradiation system 2 may emit ultraviolet light to cure the curable composition. In this case, the first holding unit 3 needs to be configured to hold a template, such as an imprint mold having projections and depressions. The use of an imprint mold as a template allows the above-described foreign substance apparatus to serve as a molding apparatus (imprint apparatus) that form projections and depressions on and in the curable composition supplied to the second substrate. The use of a superstrate having a flat surface as a template to be held by the first holding unit 3 allows the above-described foreign substance apparatus to serve as a molding apparatus (flattening apparatus) that flattens the surface of the second substrate.

### Foreign Substance Inspection Method

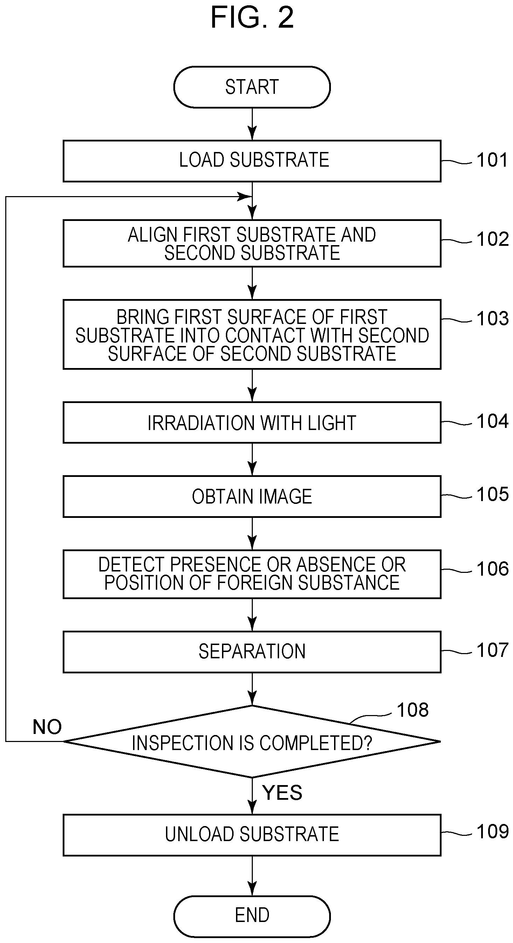

Fig. 2 is a flowchart illustrating steps of an inspection process for inspecting for a foreign substance on the second surface of the second substrate 10 in contact with the first surface of the first substrate 8 by using the foreign substance inspection apparatus 1.

In step 101, the second substrate 10 is loaded into the foreign substance inspection apparatus 1. The second substrate 10 is loaded onto the substrate chuck 16 of the second holding unit 4 by a substrate conveying mechanism (not illustrated).

In step 102, the first substrate 8 and the second substrate 10 are aligned before the substrates are brought into contact with each other. For example, the first substrate 8 and the second substrate 10 are aligned by detecting light from the mark on the first substrate 8 and light from the mark on the second substrate 10 through the detector 12.

In step 103, the first substrate 8 and the second substrate 10 are brought close to each other to bring the first surface of the first substrate 8 into contact with the second surface of the second substrate 10 (contact step). At this time, any liquid, such as an imprint resist, does not exist between the first surface and the second surface.

In step 104, the light irradiation system 2 applies light 9 to the first surface of the first substrate 8 and the second surface of the second substrate 10 in contact with each other (light irradiation step). The light irradiation system 2 irradiates at least the whole of the mesa portion 8a in contact with the second surface with light.

In step 105, an image of reflected light from the first and second surfaces is obtained for foreign substance inspection (image obtaining step).

In step 106, the presence of a foreign substance, or the absence of a foreign substance, or the position of a foreign substance is determined based on the image obtained in step 105.

In step 107, the second substrate 10 is separated from the first substrate 8 (separation step).

After the second substrate 10 is separated from the first substrate 8 in step 107, whether the foreign substance inspection process for a designated shot region on the substrate 10 is completed is determined in step 108. If the completion of the foreign substance inspection process is determined in step 108, the substrate 10 is unloaded from the foreign substance inspection apparatus 1 in step 109. If the foreign substance inspection process is not completed, the process returns to step 102. The first substrate and the second substrate are relatively moved to the next inspection position (shot region). The above steps are repeated until the foreign substance inspection process is completed.

### Principle of Foreign Substance Inspection

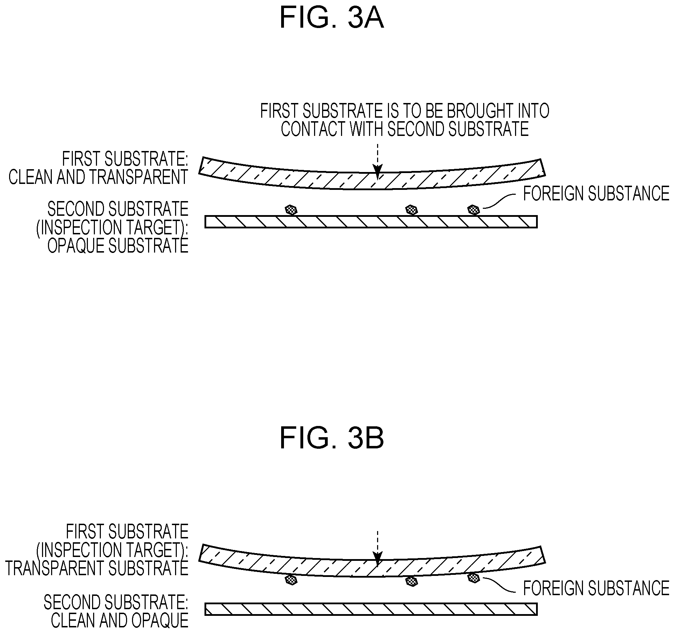

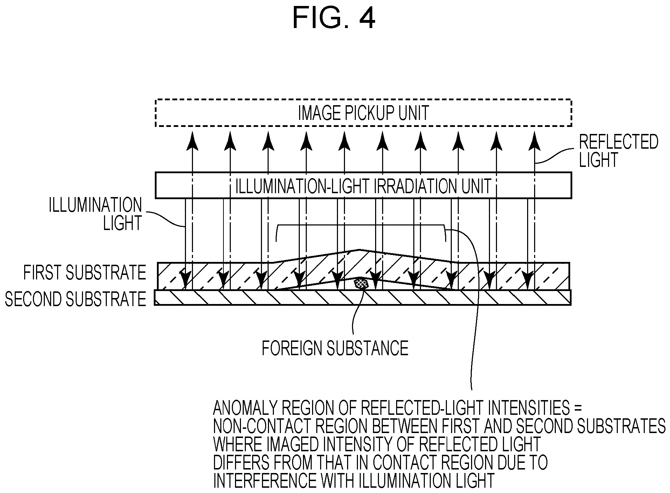

The principle of foreign substance detection according to an embodiment of the present disclosure will now be described with reference to Figs. 3A, 3B, and 4.

Figs. 3A and 3B are schematic diagrams illustrating the first and second substrates to be brought into contact with each other. Fig. 3A illustrates an embodiment in which the first substrate is a clean, transparent substrate and the second substrate is an opaque substrate to be inspected. Fig. 3B illustrates an embodiment in which the first substrate is a transparent substrate to be inspected and the second substrate is a clean, opaque substate.

If a substrate to be inspected has a foreign substance thereon, a gap corresponding to the height of the foreign substance is formed between the first and second substrates as illustrated in Fig. 4. This gap is a space that spreads around the foreign substance when at least one of the substrates bends. A region with the gap will be referred to as a non-contact region. A region where the second substrate is in contact with the first substrate with a gap of substantially zero nanometers therebetween will be referred to as a contact region.

Irradiation with illumination light through the transparent first substrate 8 or the second substrate produces reflected light between the first surface of the first substrate and the second surface of the second substrate. The intensity of reflected light in the contact region differs from that in the non-contact region. Thus, the non-contact region, or the presence of a foreign substance, can be detected based on the difference between the intensities of light received by the image pickup unit.

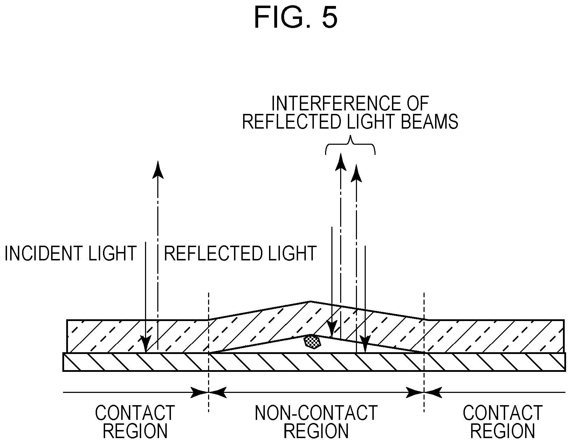

The reason why the intensity of reflected light in the contact region differs from that in the non-contact region will now be described with reference to Fig. 5. In the contact region, illumination light is reflected mainly by an interface between the first and second substrates. In the non-contact region, since the air exists in a gap between the first and second substrates, illumination light is reflected by two different interfaces, or the interface between the first substrate and the air and the interface between the air and the second substate. Such light beams reflected by the two interfaces interfere with each other. The extent of interference depends on a distance between the two interfaces. In other words, the intensity of reflected light contains information on the distance between the first and second substrates, or the height of a foreign substance.

It is assumed herein that illumination light has a wavelength of λ nm. When the distance between the first and second substrates is λ/4, reflected light has a minimum intensity. When the distance between the first and second substrates is λ/2, reflected light has a maximum intensity. For example, assuming that monochromatic light having a wavelength of 405 nm is used as illumination light, a foreign substance having a height of approximately 101 nm can be detected as a minimum reflected-light intensity region based on a captured image.

For the second substrate to be inspected, the first substrate to be used needs to have an optically flat inspection-region surface with no foreign substance. For this reason, the first substrate can be cleaned to remove a foreign substance before inspection. The first substrate can be inspected to determine the absence of a foreign substance. The flatness of the first substrate can be checked.

For such cleaning, foreign substance removal, and flatness inspection for substrates, cleaning apparatuses, foreign substance inspection apparatuses, and surface geometry measuring apparatuses are available in the semiconductor industry.

Cleaning apparatuses and foreign substance inspection apparatuses for a wafer-shaped substrate or a rectangular substrate that measures 6 × 6 × 0.25 inches are in widespread use. For this reason, each of the first and second substrates can be a wafer-shaped substrate or a rectangular substrate measuring 6 × 6 × 0.25 inches.

### Molding Process for Substrate after Foreign Substance Inspection

After the second substrate is inspected by using the above-described foreign substance inspection method, an apparatus is controlled to perform a molding process, such as imprinting, only on a region determined to have no foreign substance on the second substrate.

The molding process may be performed by using the molding apparatus incorporated in the foreign substance inspection apparatus in the above-described manner. The second substrate may be loaded into a separate imprint apparatus and be subjected to the molding process.

After the second substrate is inspected, the molding apparatus (imprint apparatus) can be controlled so that the molding process (imprinting) is not performed on a region where the position of a foreign substance on the second substrate is determined.

After the second substrate is inspected by using the above-described foreign substance inspection method, the second substrate determined to have a foreign substance having a predetermined size or more or a predetermined number or more of foreign substances may be cleaned.

The present disclosure will be described below with more specific embodiments.

### First Embodiment

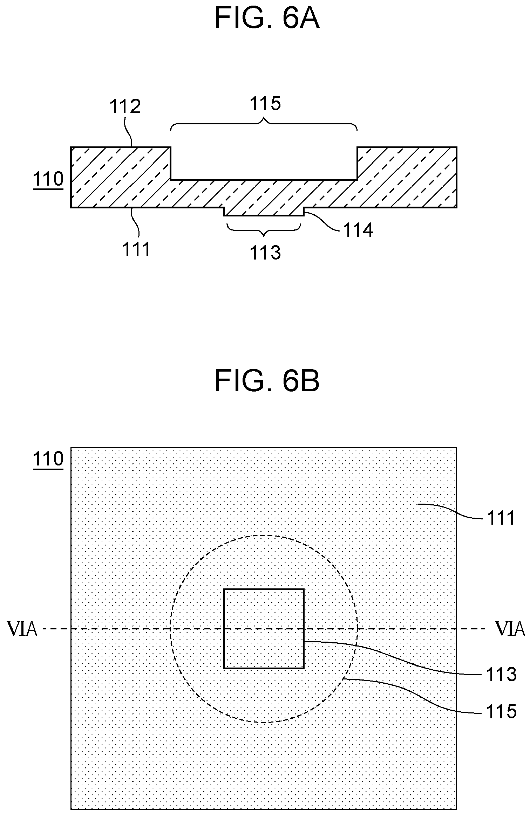

This embodiment illustrates an example first substrate. As illustrated in Fig. 6A, the first substrate has a first surface and a second surface. The second surface has a recess depressed toward the first surface. The first surface has a protruding step structure. The step structure is formed in a narrow region located inward from the recess.

Fig. 6A is a schematic sectional view of an example first substrate. Fig. 6B is a schematic plan view of the example first substrate. Fig. 6A illustrates a section taken along line VIA-VIA in Fig. 6B.

A first substrate 110 includes a transparent base material and has a first main surface 111, serving as a first surface, and a second main surface 112. The first main surface 111 has an inspection region 113. The inspection region 113 has a protruding step structure (mesa structure) 114, which is higher than its surrounding portion. The second main surface 112, which is opposite the first main surface 111, has a recess 115 that is aligned with the inspection region 113 of the first main surface and that has an area larger than that of the inspection region 113 of the first main surface. The above-described protruding step structure is located in a central portion of the base material and has an area that is less than or equal to 10% and greater than or equal to 0.5% of the area of the first main surface of the base material.

The first substrate 110 can measure 6 × 6 × 0.25 inches. For a material for the first substrate 110, a highly elastic material having a modulus of elasticity of 50 GPa or more, particularly quartz glass, can be used. A quartz glass substrate having the above-described size is widely available as a photomask base material in the semiconductor industry.

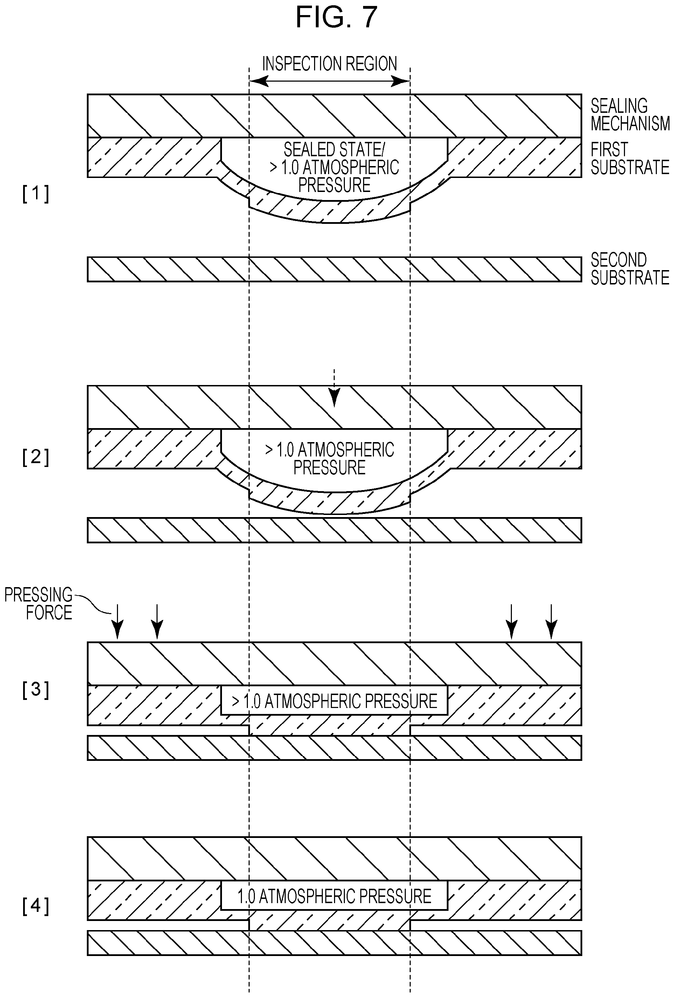

A method of bringing the first surface (first main surface 111) of the first substrate into contact with a part of the second surface of the second substrate and then expanding the area of contact to the entire inspection region will now be described with reference to Fig. 7. A recessed portion of the first substrate is sealed, and a nitrogen gas is supplied to the recessed portion so that a space inside the sealed recessed portion is at a pressure of, for example, 1.5 atmospheres, thus curving the recessed portion toward the second substrate (Fig. 7[1]). The first substrate with the inspection region curved is moved downward, thus bringing a central portion of the inspection region into contact with the second substrate (Fig. 7[2]). An outer portion of the inspection region of the first substrate is gradually brought into contact with the second substate while a pressing force is increased to, for example, 42 N (Fig. 7[3]). When the entire inspection region is in tight contact with the second substrate (Fig. 7[4]), the pressure in the recessed portion is released to atmospheric pressure. A foreign substance on the inspection region can be detected by applying illumination light to the inspection region and capturing an image of reflected light from the inspection region in steps [2] and [3] of Fig. 7.

### Second Embodiment

Foreign substance inspection according to a second embodiment of the present disclosure will be described with reference to Figs. 1 and 3A.

In this embodiment, as illustrated in Fig. 3A, a second substrate that is opaque to illumination light is an inspection target. As illustrated in Fig. 1, the first holding unit 3 holds the first substrate 8, which is transparent to illumination light.

The first driving mechanism 38 brings the first substrate close to the opaque second substrate to bring a part of the first substrate into contact with the opaque second substrate and then brings the first substrate into contact with the opaque second substrate to increase the area of contact between the first substrate and the opaque second substrate.

After that, illumination light from the light irradiation system 2 is applied to the opaque substrate through the first substrate. The image pickup unit 6 captures an image of a region sandwiched between the opaque substrate and the first substrate to obtain, as an image, interference colors produced by reflected light from the first substrate and reflected light from the opaque substrate.

When the opaque second substrate and the first substrate are in contact with each other, a liquid such as an imprint material is substantially absent in a gap between the substrates. The presence of a foreign substance on the opaque substrate and position information of the foreign substance can be determined based on the interference colors of the image obtained by the image pickup unit 6.

### Third Embodiment

Foreign substance inspection according to a third embodiment of the present disclosure will be described with reference to Figs. 1 and 3B.

In this embodiment, as illustrated in Fig. 3B, a first substrate that is transparent to illumination light is an inspection target.

As illustrated in Fig. 1, the first holding unit 3 holds the first substrate 8, which is transparent to illumination light.

The first driving mechanism 38 brings the first substrate close to the second substrate to bring a part of the first substrate into contact with the second substrate and then brings the first substrate into contact with the opaque second substrate to increase the area of contact between the first substrate and the opaque second substrate.

After that, illumination light from the light irradiation system 2 is applied to the opaque second substrate through the first substrate. The image pickup unit 6 captures an image of a region sandwiched between the opaque second substrate and the first substrate to obtain, as an image, interference colors produced by reflected light from the first substrate and reflected light from the opaque substrate.

When the opaque second substrate and the first substrate are in contact with each other, a liquid is substantially absent in a gap between the substrates. The presence of a foreign substance on the transparent substate and position information of the foreign substance can be determined based on the interference colors of the image obtained by the image pickup unit 6.

### Embodiment of Article Manufacture

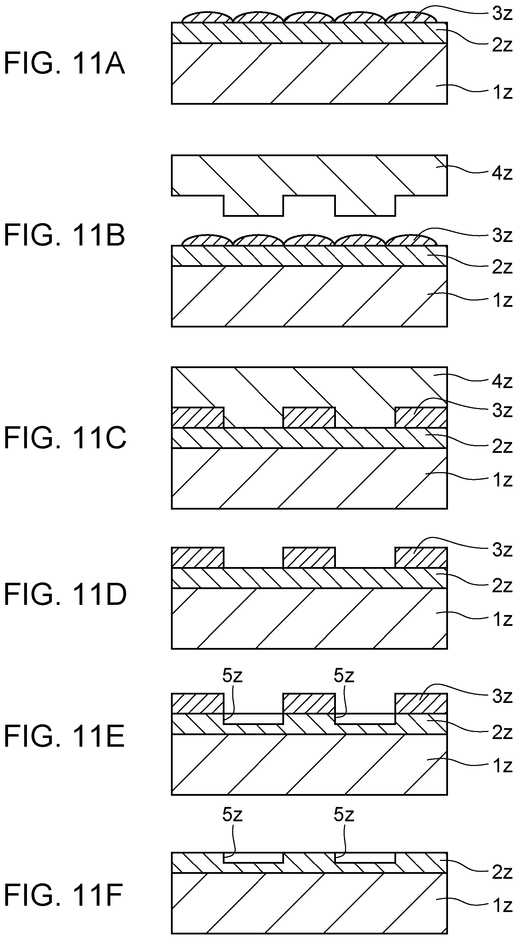

The present disclosure is also applicable to article manufacture. Article manufacture according to an embodiment of the present disclosure will now be described with reference to Figs. 11A to 11F.

A patterned cured product of a curable composition formed by using a molding apparatus can be permanently included as at least a part of any of various articles or be temporarily used to manufacture various articles. Examples of the article include an electrical circuit element, an optical element, a MEMS device, a recording element, a sensor, and a mold. Examples of the electrical circuit element include a volatile or nonvolatile semiconductor memory, such as a dynamic random access memory (DRAM), a static random access memory (SRAM), a flash memory, or a magnetoresistive random access memory (MRAM), and a semiconductor device, such as a large-scale integrated circuit (LSI), a charge-coupled device (CCD), an image sensor, or a field-programmable gate array (FPGA). Examples of the optical element include a diffractive grating and a polarizer. Examples of the mold include an imprint mold (replica mold).

The patterned cured product is directly used as a component of at least a part of the above-described article or is temporarily used as a resist mask. The resist mask is removed after etching, ion implantation, or any other process is performed in a substrate processing step.

A specific method of manufacturing an article will now be described. As illustrated in Fig. 11A, a substrate 1z, such as a silicon wafer, having thereon a material 2z to be processed, such as an insulating material, is prepared. A curable composition 3z is then applied to the surface of the material 2z by using an ink-jet method, for example. Fig. 11A illustrates the curable composition 3z in the form of droplets on the substrate.

As illustrated in Fig. 11B, an imprint mold 4z having a surface with projections and depressions is disposed such that the projections and the depressions face the curable composition 3z on the substrate. As illustrated in Fig. 11C, the mold 4z is brought into contact with the curable composition 3z on the substrate 1z, and pressure is applied to the mold 4z. The curable composition 3z fills gaps between the mold 4z and the material 2z. When the curable composition 3z in this state is irradiated with light as curing energy through the mold 4z, the curable composition 3z is cured.

As illustrated in Fig. 11D, when the mold 4z is separated from the substrate 1z after the curable composition 3z is cured, a patterned cured product of the curable composition 3z is formed on the substrate 1z. The patterned cured product is shaped such that the depressions of the mold correspond to projections of the cured product. In other words, the projections and the depressions of the mold 4z are transferred to the curable composition 3z.

As illustrated in Fig. 11E, etching using the patterned cured product as an etch-resistant mask removes portions of the surface of the material 2z that have no cured product or a thin layer of the cured product, thus forming grooves 5z. The portions having the thin layer of the cured product can be removed in advance by using a different type of etching from the above-described etching.

As illustrated in Fig. 11F, removing the patterned cured product can provide an article with the grooves 5z in the surface of the material 2z. For example, when a silicon wafer is used as the substrate 1z, for example, an electrical circuit element such as a semiconductor device, a MEMS device, a recording element, or a sensor can be obtained as an article. When a quartz glass wafer is used as the substrate 1z, for example, a replica mold or an optical element can be obtained as an article.

In this embodiment, the patterned cured product is removed. After processed, the patterned cured product may remain unremoved and be used as, for example, an insulating interlayer included in, for example, a semiconductor device, a pattern structure made of an optical material included in an optical element, or a component of an article.

### Examples

The present disclosure will be described in more detail below with examples.

### Example 1: Inspection of Opaque Second Substrate with Transparent First Substrate in Step-and-Repeat Manner

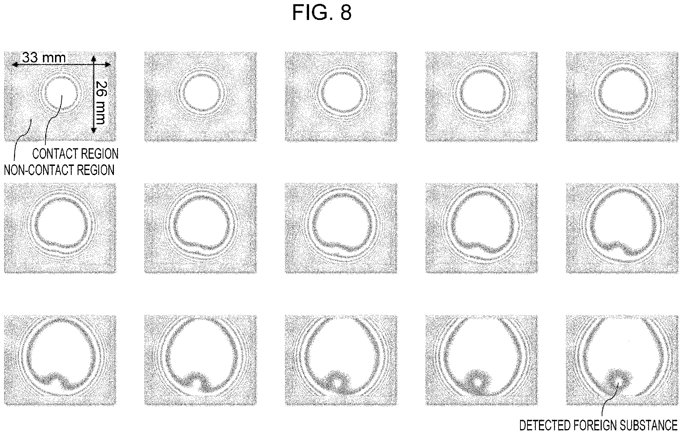

An inspection target was a silicon wafer having a diameter of 300 mm. A first substrate made of quartz glass with an inspection region, as illustrated in Figs. 6A and 6B, measuring 26 × 33 mm was used. Images of the inspection region were captured at 60 frames per second by using the method of bringing the first substrate into contact with the inspection target without any liquid, such as a resist, therebetween as illustrated in Fig. 7. Fig. 8 illustrates images captured on a frame-by-frame basis.

A foreign substance located below a central portion of the inspection region was successfully detected in less than 0.25 seconds since the start of contact. Because the foreign substance was surrounded by a single ring-shaped dark portion, the height of the foreign substance was estimated to be greater than λ/4 and less than 3λ/4.

Repeating the same inspection process while shifting the inspection region allows the whole of the silicon wafer having a diameter of, for example, 300 mm, to be subjected to foreign substance inspection.

### Example 2: Full Batch Inspection of Transparent Second Substrate with Opaque First Substrate

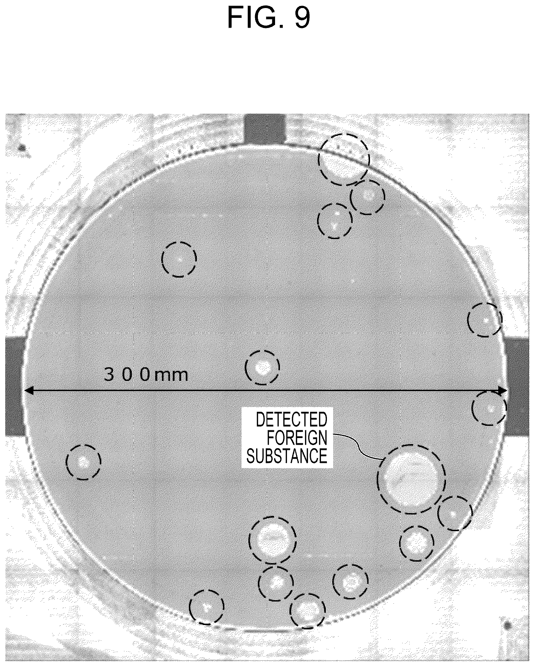

An inspection target was a quartz glass wafer having a diameter of 300 mm. A clean, flat silicon wafer was prepared as an opaque first substrate. The quartz glass wafer and the silicon wafer were disposed opposite each other. A central portion of the quartz glass wafer was then bent toward and brought into contact with the silicon wafer. After that, the quartz glass wafer was gradually brought into contact, from the central portion to the edge of the quartz glass wafer, with the silicon wafer for ten seconds. A still image, as illustrated in Fig. 9, was captured under conditions where the wafers were in full contact with each other. Thus, a large number of foreign substances were successfully detected.

### Example 3: Theoretical Calculation of Non-Contact Region Generated by Foreign Substance

Deformation behavior of the first substrate used in Example 1 that was caused by a foreign substance sandwiched between the substrate and an inspection target was analyzed by using the finite-element analysis software program, Abaqus, available from Dassault Systèmes. A central portion of an inspection region of the first substrate made of quartz glass was brought into contact with a silicon wafer having a diameter of 300 mm and a modulus of elasticity of 190 GPa and having thereon a cylindrical foreign substance having a height of 0.1 µm. A pressing force of 42 N was applied to the first substrate in contact with the silicon wafer.

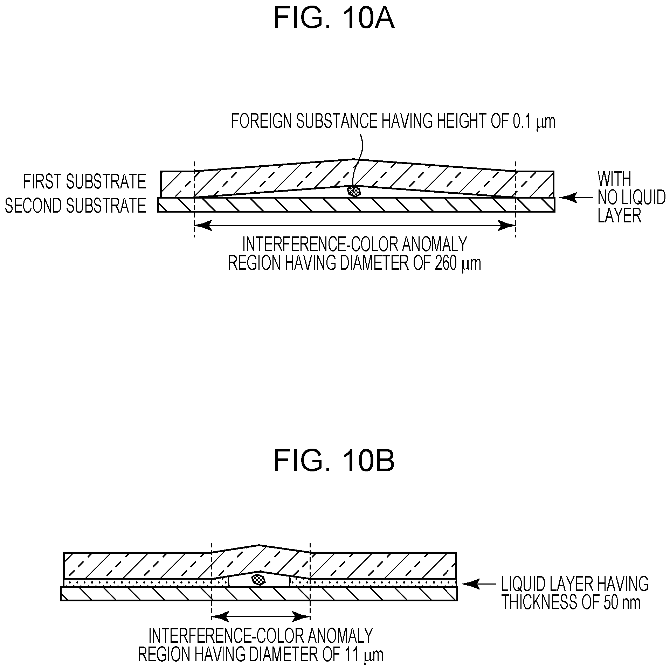

The occurrence of a non-contact region having a diameter of approximately 260 µm around the foreign substance was calculated (Fig. 10A). Because an interference-color anomaly occurs in the region having a diameter of approximately 260 µm greater than a resolution of 70 µm of a digital still camera used for image capture, the presence of a foreign substance can be detected.

### Comparative Example 1: Theoretical Calculation of Non-Contact Region Generated by Foreign Substance

The same first and second substrates as those in Example 3 were used under the same conditions of a foreign substance as those in Example 3. Deformation behavior of the first substrate with a liquid layer having a thickness of 50 nm between the first and second substrates was calculated. A first surface of the first substrate and a second surface of the second substrate were not in direct contact with each other due to the liquid layer. A meniscus pressure generated by the liquid layer was calculated to be 1.18 MPa. The diameter of a non-contact region formed around the foreign substance was calculated to be approximately 11 µm (Fig. 10B). The non-contact region is seemingly smaller than that in Example 3 because the meniscus pressure caused the first substrate to be strongly drawn toward the second substrate and the first substrate deformed to fit the foreign substance. The diameter of an interference-color anomaly region is approximately 11 µm, which is less than a resolution of 70 µm of the digital still camera used for image capture. The interference-color anomaly region, or the foreign substance, cannot be detected.

The present disclosure provides a novel technique related to a foreign substance inspection method for inspecting a substrate for a foreign substance.

While the present disclosure has been described with reference to example embodiments, it is to be understood that the disclosure is not limited to the disclosed example embodiments. The scope of the following claims encompasses all such modifications and equivalent structures and functions.

## Claims

1. A foreign substance inspection method for inspecting for a foreign substance, the method comprising:
bringing a first surface of a first substrate into contact with a second surface of a second substrate to cause the first and second surfaces to face each other;
obtaining an image of reflected light from the first and second surfaces in contact with each other; and
determining, based on the obtained image, the presence of a foreign substance, or the absence of a foreign substance, or the position of a foreign substance.

2. The method according to Claim 1, wherein the first substrate comprises a light-transmissive material.

3. The method according to Claim 2, further comprising:
applying light to the first and second surfaces through the first substrate.

4. The method according to Claim 1, wherein the bringing method step includes bringing the first surface of the first substrate into contact with the second surface of the second substrate to form a contact region where the first and second surfaces are in contact with each other and a non-contact region where the first and second surfaces are not in contact with each other due to a foreign substance.

5. The method according to Claim 4, wherein the obtaining method step includes obtaining an image of the non-contact region expanding around the foreign substance bending at least one of the first surface and the second surface.

6. The method according to Claim 3, wherein the second substrate comprises a material that is opaque to the light.

7. The method according to Claim 6, wherein the first substrate is an inspection target substrate.

8. The method according to Claim 6, wherein the second substrate is an inspection target substrate.

9. The method according to Claim 2, wherein the first substrate is a quartz glass wafer.

10. The method according to Claim 6, wherein the second substrate is a silicon wafer.

11. The method according to Claim 1, wherein the first surface of the first substrate and the second surface of the second substrate have substantially the same size.

12. The method according to Claim 1, wherein the first surface of the first substrate has a smaller size than the second surface of the second substrate, and inspection is repeatedly performed on a plurality of regions of the second surface while the position of contact between the first and second surfaces is being shifted.

13. The method according to Claim 3, wherein the light is monochromatic light.

14. A molding method comprising:
inspecting the second substrate by using the foreign substance inspection method according to Claim 8; and
controlling an apparatus to perform a molding process only on a region determined to have no foreign substance on the second substrate.

15. A molding method comprising:
inspecting the second substrate by using the foreign substance inspection method according to Claim 8; and
controlling an apparatus to keep the apparatus from performing a molding process on a region where the position of a foreign substance on the second substrate is determined.

16. A molding method comprising:
inspecting the second substrate by using the foreign substance inspection method according to Claim 8; and
cleaning the second substrate determined to have a foreign substance having a predetermined size or more or a predetermined number or more of foreign substances.

17. A foreign substance inspection apparatus for inspecting for a foreign substance, the apparatus comprising:
a first holding unit (3) configured to hold a first substrate;
a second holding unit (4) configured to hold a second substrate;
a driving mechanism (38) configured to bring a first surface of the first substrate into contact with a second surface of the second substrate to cause the first and second surfaces to face each other;
an image pickup unit (6) configured to obtain an image of reflected light from the first and second surfaces in contact with each other; and
a controller (7) configured to determine, based on the obtained image, the presence of a foreign substance, or the absence of a foreign substance, or the position of a foreign substance.

18. The apparatus according to Claim 17, further comprising:
a light irradiation unit (2) configured to apply light to the first and second surfaces.

19. A molding apparatus comprising:
the foreign substance inspection apparatus (1) according to Claim 18; and
a supply unit (5) configured to supply a curable composition to the second substrate,
wherein the first holding unit is capable of holding a template, and
wherein the curable composition supplied to the second substrate is brought into contact with the template by the driving mechanism, and the curable composition is cured by the light irradiation unit.

20. An article manufacturing method comprising:
molding a composition on a substrate by using the molding apparatus according to Claim 19;
processing the substrate subjected to the molding; and
manufacturing an article from the substrate subjected to the processing.
